# EUROPEAN PATENT APPLICATION

(11) **EP 4 819 206 A1**
(43) Date of publication of application: **07.10.2026**
(21) Application number: 24897209.3
(22) Date of filing: 01.11.2024
(51) Int. Cl.: H01L 23/538

(54) **ELECTRONIC DEVICE**

(30) Priority: 30.11.2023 JP 2023203322
(71) Applicant: Rapidus Corporation, Tokyo 102-0083 (JP)
(72) Inventor: NONAKA Toshihisa, Tokyo 102-0083 (JP)
(74) Representative: MFG Patentanwälte Meyer-Wildhagen Meggle-Freund Gerhard PartG mbB
(86) International application number: PCT/JP2024/039125
(87) International publication number: WO 2025/115520

(57) **Abstract**

An electronic device capable of mounting bridges on a wiring layer with high positional accuracy is to be provided.

An electronic device 1 includes bridges (31 (31A, 31B)) that electrically connect a plurality of electronic components (20 (20A, 20B, 20C)) and a wiring layer (4) having wirings, and the bridges (31 (31A, 31B)) are metal-joined to the wiring layer (4). The bridges (31) include bridge wirings (311) that electrically connect the electronic components (20) to one another.

## Description

### Technical Field

The present invention relates to an electronic device.

### Background Art

Patent Literature 1 discloses a technique for connecting semiconductor chips to each other with an interconnect chip.

### Citation List

### Patent Literature

Patent Literature 1: JP 2020-528220 W

### Summary of Invention

### Technical Problem

In Cited Literature 1, the positional accuracy at the time of fixing bridges is not taken into consideration.

The present invention aims to provide an electronic device capable of mounting bridges on a wiring layer with high positional accuracy.

### Solution to Problem

An electronic device according to the present invention includes: a bridge that electrically connects a plurality of electronic components; and a wiring layer including wirings, in which the bridge is metal-joined to the wiring layer.

### Advantageous Effects of Invention

According to the present invention, it is possible to provide an electronic device capable of mounting bridges on a wiring layer with high positional accuracy.

### Brief Description of Drawings

Fig. 1 is a cross-sectional view of an electronic device according to an embodiment of the present invention.
Fig. 2 is a cross-sectional view of the electronic device illustrated in Fig. 1 in a disassembled state.
Fig. 3 is an external view of the electronic device according to the embodiment as viewed from above.
Fig. 4A is a drawing illustrating a process of manufacturing bridges of the electronic device according to the embodiment, and is a drawing illustrating a glass base preparing step.
Fig. 4B is a drawing illustrating a via filling step of forming part of through bridge vias by performing via filling on through-holes formed in a glass base material.
Fig. 4C is a drawing illustrating an insulating film forming step of forming a bridge insulating layer on the glass base material.
Fig. 4D is a drawing illustrating a bridge wiring forming step of forming a bridge wiring on the bridge insulating layer.
Fig. 4E is a drawing illustrating an insulating film forming step of forming a bridge insulating layer on the bridge wiring.
Fig. 4F is a drawing illustrating a via filling step of forming through bridge vias by performing via filling on openings formed in the bridge insulating layer.
Fig. 4G is a drawing illustrating a bridge wiring forming step.
Fig. 4H is a drawing illustrating a bump electrode forming step.
Fig. 5A is a drawing illustrating a layer stacking process in the electronic device according to the embodiment, and is a drawing illustrating a release layer forming step of forming a release layer on a panel carrier.
Fig. 5B is a drawing illustrating a wiring forming step of forming first layer line wirings.
Fig. 5C is a drawing illustrating a wiring layer forming step of forming a wiring layer and an insulating layer.
Fig. 5D is a drawing illustrating a bridge mounting step of mounting bridges on the wiring layer.
Fig. 5E is a drawing illustrating a resist film forming step.
Fig. 5F is a drawing illustrating a pillar forming step of forming pillars by performing via filling on holes formed in the resist film.
Fig. 5G is a drawing illustrating a resist film removing step of removing the resist film.
Fig. 5H is a drawing illustrating a molding step of covering the bridges and the pillars with an insulating layer.
Fig. 5I is a drawing illustrating a grinding step of grinding the surface of the insulating layer.
Fig. 5J is a drawing illustrating an electrode forming step of forming electrodes with thin metal films.
Fig. 5K is a drawing illustrating an electronic component mounting step of mounting electronic components on a connection layer.
Fig. 5L is a drawing illustrating a molding step of covering the electronic components with an insulating layer.
Fig. 5M is a drawing illustrating a grinding step of grinding the surface of the insulating layer.
Fig. 5N is a drawing illustrating a panel carrier removing step of removing the panel carrier.
Fig. 5O is a drawing illustrating a bump electrode forming step of forming bump electrodes on the wiring layer.
Fig. 6A is an external view of a bridge according to a modification of the present embodiment as viewed from above.
Fig. 6B is an external view of a connection layer according to the modification of the present embodiment as viewed from above.
Fig. 6C is a drawing illustrating an alignment step in the bridge mounting step of mounting the bridges on the wiring layer.
Fig. 7 is a cross-sectional view of an electronic device according to another embodiment of the present invention.

### Description of Embodiments

In the following, an electronic device 1 according to an embodiment of the present invention will be described with reference to the drawings.

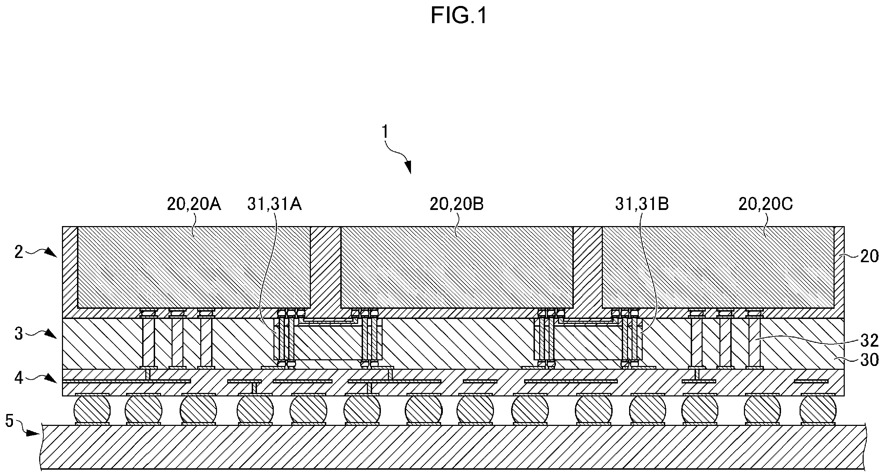

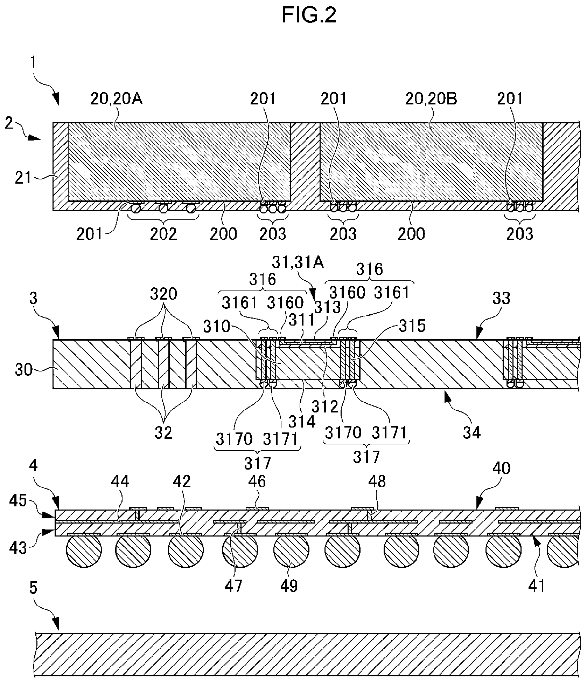

First, the electronic device 1 according to an embodiment is described with reference to Figs. 1 and 2. Fig. 1 is a cross-sectional view of the electronic device 1 according to an embodiment of the present invention. Fig. 2 is a cross-sectional view of the electronic device 1 shown in Fig. 1 in a disassembled state. Note that, in Fig. 1, reference numerals for detailed components are not shown.

As illustrated in Figs. 1 and 2, the electronic device 1 according to the present embodiment includes an electronic component layer 2, a connection layer 3, and a wiring layer 4 (hereinafter referred to as the "wiring layer 4") serving as a re-distribution layer (RDL). The electronic device 1 is mounted on a substrate 5.

The electronic component layer 2 is formed with a plurality of electronic components 20 that are a first electronic component 20A, a second electronic component 20B, and a third electronic component 20C, and are covered with an insulating layer 21 to be described later. The electronic component layer 2 processes data with the electronic components 20. Also, the electronic component layer 2 stores data and a program. The electronic component layer 2 executes a program. The electronic component layer 2 performs signal processing. The electronic component layer 2 performs communication. The electronic component layer 2 interfaces with a sensor device.

In the description below, in some cases where there is no need to identify the first electronic component 20A, the second electronic component 20B, and the third electronic component 20C, the first electronic component 20A, the second electronic component 20B, and the third electronic component 20C will be referred to simply as the "electronic components 20".

The connection layer 3 is formed with one or a plurality of bridges 31 that are covered with an insulating layer 30 to be described later. The connection layer 3 electrically connects the electronic component layer 2 and the wiring layer 4. The connection layer 3 is formed between the electronic component layer 2 and the wiring layer 4. The connection layer 3 may function as a so-called interposer.

In the present embodiment, the plurality of bridges 31 includes a first bridge 31A and a second bridge 31B. In the following description, in some cases where there is no need to identify the first bridge 31A and the second bridge 31B, the first bridge 31A and the second bridge 31B will be referred to simply as the "bridges 31".

The wiring layer 4 transmits a signal that has been output from the electronic component layer 2. The wiring layer 4 physically supports the electronic component layer 2 and the connection layer 3. The wiring layer 4 supplies electric charges to the electronic component layer and/or the connection layer 3. The wiring layer 4 is placed on the opposite side of the connection layer 3 from the electronic component layer 2. The wiring layer 4 includes two or more layers including a layer of signal wirings for signal transmission and ground wirings, and a layer of power supply wirings for charge supply and ground wirings. From the viewpoint of stable charge supply, the power supply wirings are preferably in a different layer from the ground wirings, and, in this case, the number of layers in the wiring layer 4 is three or larger. Further, it is also preferable that the layer of the signal wirings for signal transmission and the ground wirings is divided into two or more layers, or the signal wirings and the ground wirings are placed in different layers from each other from the viewpoint of enhancement of transmission signal quality.

The substrate 5 physically supports the electronic component layer 2, the connection layer 3, and the wiring layer 4. The substrate 5 functions as a wiring substrate. The substrate 5 is placed on the opposite side of the wiring layer 4 from the electronic component layer 2 and the connection layer 3. The substrate 5 may be a glass epoxy substrate, a substrate in which an insulating layer and a wiring layer are provided on a glass base material, or the like.

### <Electronic Component Layer>

As illustrated in Figs. 1 and 2, the electronic component layer 2 includes the plurality of electronic components 20 and the insulating layer 21. In the present embodiment, the plurality of electronic components 20 includes the first electronic component 20A, the second electronic component 20B, and the third electronic component 20C.

The electronic components 20 process data. The electronic components 20 store data and a program. The electronic components 20 execute a program. The electronic components 20 perform signal processing. The electronic components 20 perform communication. The electronic components 20 interface with a sensor device. Each electronic component 20 may perform a different function. The electronic components 20 are logic ICs, for example. Each electronic component 20 may be a system on a chip (SoC). The electronic components 20 may include a memory IC. The electronic components may be, for example, double data rates (DDRs), low-power double data rates (LPDDRs), or high bandwidth memories (HBMs).

The electronic components 20 may be arranged so that the electronic components 20 are located adjacent to one another. That is, the first electronic component 20A, the second electronic component 20B, and the third electronic component 20C may be arranged side by side in the electronic component layer 2. Note that the number of the electronic components 20 is not limited to three. The number of electronic components may be two, three or larger, or four or larger.

More specifically, the first electronic component 20A and the second electronic component 20B may be arranged adjacent to each other. The second electronic component 20B and the third electronic component 20C may be arranged adjacent to each other. Hereinafter, any description regarding the first electronic component 20A and the second electronic component 20B adjacent to each other can be applied to any other pair of the n-th electronic component and the (n+1)-th electronic component adjacent to each other, unless otherwise specified. Here, n is a natural number.

Having the plurality of electronic components 20, the electronic device 1 can process a larger amount of information and execute a larger number of functions than in a case where there is one electronic component 20. For example, if the number of the electronic components 20 is three or larger, a larger amount of information can be processed, and a larger number of functions can be executed.

An integrated circuit (IC) is formed in each electronic component 20. A specific example of the plurality of electronic components 20 is an IC chip (a semiconductor chip). Semiconductor elements are densely arranged on the IC chip. As an example, the IC chip includes a chip substrate (not shown), transistors, chip wirings, and a chip insulating layer.

The chip substrate is the substrate of the IC chip. The transistors function as electronic switches, and control electric current in accordance with a change in voltage. An example of the transistors is metal-oxide-semiconductor field-effect transistors (MOSFETs). The chip wirings are electronic paths for transmitting signals between the transistors and other components. As an example of the chip wirings, a fine pattern is formed with a conductive metal (aluminum or copper) as the material. The chip insulating layer suppresses short-circuiting of the chip substrate, the transistors, and the chip wirings.

The insulating layer 21 seals the peripheries of the electronic components 20 including the transistors. The insulating layer 21 is, for example, an organic insulating layer such as an epoxy resin layer. The organic insulating layer may contain inorganic particles of silica, alumina, or the like. As the inorganic particles are contained, the linear expansion coefficient and the elastic modulus can be controlled. The insulating layer 21 may be a molded resin. As an example, the insulating layer 21 can be formed by transfer molding in which a pellet-like material is heated and softened in a plunger, and a resin is then pushed into a metallic mold, is cooled and solidified, and is thus molded.

Alternatively, the insulating layer 21 can be formed by compression molding in which a liquid or granular molded resin is supplied beforehand into an opened metallic mold, the metallic mold is closed, and heated pressure molding is then performed on the resin. The insulating layer 21 may be formed by laminating a buildup resin film and thermally curing the laminate.

Each electronic component 20 includes a first facing portion 200 and electronic-component-side electrodes 201. Bump electrodes 202 and bump electrodes 203 are formed on the electronic-component-side electrodes 201.

The first facing portion 200 faces the bridge 31. Specifically, the first facing portion 200 faces the bridge 31 via the insulating layer 21 of the electronic component layer 2. The first facing portion 200 may be a surface facing the bridge 31. Specifically, the first facing portion 200 may be a surface that faces the bridge 31 via the insulating layer 21 of the electronic component layer 2. The first facing portion 200 may be a lower surface of the electronic component 20 in a case where the electronic device 1 illustrated in Fig. 1 is placed on a horizontal plane.

The electronic-component-side electrodes 201 are input/output terminals of the current and signals that are input or output to and from the electronic component 20. The electronic-component-side electrodes 201 are formed on the first facing portion 200. As an example, the electronic-component-side electrodes 201 are formed with copper, a copper-aluminum alloy, tin, a tin-silver alloy, a tin-copper-silver alloy, or a stack or mixture of these materials. The electronic-component-side electrodes 201 are electrically connected to pillars 32 of the connection layer 3 described later via the bump electrodes 202. The electronic-component-side electrodes 201 are electrically connected to the bridges 31 of the connection layer 3 described later via the bump electrodes 203. As an example, of the bump electrodes 203, the one connected to a bridge electrode 3160 (described later) of a bridge-side first electrode 316 (described later) is a signal line terminal, and, of the bump electrodes 203, the one connected to a via electrode 3161 (described later) of the bridge-side first electrode 316 (described later) is a power supply terminal or a ground terminal.

The bump electrodes 202 and the bump electrodes 203 are formed on the electronic-component-side electrodes 201. The bump electrodes 202 and the bump electrodes 203 are formed with solder, for example. The bump electrodes 202 and the bump electrodes 203 may be formed with copper, silver, gold, tin, or an alloy of these materials. Other bump electrodes described in the present embodiment may also be formed with the same material.

The connection layer 3 includes the insulating layer 30, the bridges 31, and the pillars 32 as through-connection-layer electrodes.

The insulating layer 30 seals the peripheries of the bridges 31. The insulating layer 30 is, for example, an organic insulating layer such as an epoxy resin layer. The organic insulating layer may contain inorganic particles of silica, alumina, or the like. As the inorganic particles are contained, the linear expansion coefficient and the elastic modulus can be controlled. The insulating layer 30 may be a molded resin. As an example, the insulating layer 30 can be formed by transfer molding in which a pellet-like material is heated and softened in a plunger, and a resin is then pushed into a metallic mold, is cooled and solidified, and is thus molded. Alternatively, the insulating layer 30 can be formed by compression molding in which a liquid or granular molded resin is supplied beforehand into an opened metallic mold, the metallic mold is closed, and heated pressure molding is then performed on the resin. The insulating layer 30 may be formed by laminating a buildup resin film and thermally curing the laminate.

The bridges 31 are electrically connected to the electronic components 20. The number of the bridges 31 may be two or larger. In the present embodiment, the plurality of bridges 31 includes the first bridge 31A and the second bridge 31B. The number of the bridges may be three or larger.

According to the present embodiment, the electronic device 1 can process a larger amount of information than in a case where there is one bridge 31.

The bridges 31 electrically connect the plurality of electronic components 20 adjacent to one another. That is, the first bridge 31A (the n-th bridge) electrically connects the first electronic component 20A (the n-th electronic component) and the second electronic component 20B (the (n+1)-th electronic component) adjacent to each other. Further, the second bridge 31B (the (n+1)-th bridge) may electrically connect the second electronic component 20B (the (n+1)-th electronic component) and the third electronic component 20C (the (n+2)-th electronic component) adjacent to each other.

The pillars 32 penetrate from a facing portion 33 facing the electronic component layer 2 to a facing portion 34 facing the wiring layer 4 in the connection layer 3, and electrically connect the electronic components 20 and the wirings of the wiring layer 4. The pillars 32 are formed in the insulating layer 30.

The pillars 32 electrically connect the electronic component layer 2 and the wiring layer 4 directly to each other. The pillars 32 are formed so as to vertically penetrate the insulating layer 30 from the surface (the facing portion 33) facing the electronic component layer 2 to the surface (the facing portion 34) facing the wiring layer 4. Each pillar 32 is formed in a columnar shape, and a cavity is formed therein. A conductor is formed on the inner peripheral surface of the cavity. The cavity may be filled with a conductor. An example of the conductor is copper formed by a plating technique.

Each pillar 32 has an exposed portion as a surface exposed through the facing portion 34 on the side of the wiring layer 4. When the connection layer 3 and the wiring layer 4 are connected, the exposed portion of each pillar 32 on the side of the wiring layer 4 is electrically connected to a third-layer line wiring 46 formed in a fourth facing portion 40 of the wiring layer 4 described later.

Each pillar 32 has an exposed portion as a surface exposed through the facing portion 33 on the side of the electronic component layer 2. The exposed portion of each pillar 32 on the side of the electronic component layer 2 may be covered with a pillar electrode 320. The pillar electrode 320 is, for example, a conductive thin film. As an example, the pillar electrode 320 is formed with copper. Note that the exposed portion of each pillar 32 on the side of the electronic component layer 2 may serve as the pillar electrode 320, without the conductive thin film. When the electronic component layer 2 is joined to the connection layer 3 in the process of manufacturing the electronic device 1, the pillar electrodes 320 of the connection layer 3 are electrically connected to the bump electrodes 202 of the electronic component layer 2. The pillars 32 are used as power supply lines or ground lines for the electronic components 20, for example.

Each bridge 31 includes a base material 310 selected from silicon, ceramics, and glass, a bridge wiring 311 and a bridge insulating layer 312 constituting a bridge wiring portion, a second facing portion 313, a third facing portion 314, and a through bridge via 315 serving as a through bridge electrode. Each bridge 31 further includes the bridge-side first electrode 316 and a bridge-side second electrode 317.

Each bridge 31 is formed with the base material 310 selected from silicon, ceramics, and glass. In a case where the base material 310 is formed with glass, it is preferable to use alkali-free glass or quartz glass not containing any alkali component, from the viewpoint of electrical reliability. As the base material 310, it is also preferable to select a material having an appropriate linear expansion coefficient or elastic modulus, from the viewpoint of reliability in the relationship among the physical properties of the electronic component layer 2, the connection layer 3, the wiring layer 4, and the substrate 5.

The relative permittivity of silicon is 12, for example. The relative permittivity of alkali-free glass is 5.8, for example. The relative permittivity of quartz glass is 3.9, for example. Dielectric loss is proportional to relative permittivity. Accordingly, the higher the relative permittivity, the higher the dielectric loss. Therefore, the bridges 31 that electrically connect the plurality of electronic components 20 can reduce the dielectric loss more effectively in a case where the base material 310 is formed with glass, as compared with that in a case where the base material is formed with silicon.

The dielectric loss affects, for example, signal attenuation, bandwidth limitation, increases in delay, signal distortion, and the like in information transmission between the plurality of electronic components 20.

The dielectric loss absorbs and attenuates the energy of a signal. As a result, the signal is weakened as it travels through the wiring, and the signal quality is degraded. Signal attenuation is a factor that limits the information transmission distance.

In a wiring having a high dielectric loss, the frequency component of a signal attenuates faster. Therefore, there are cases where the bandwidth is limited. In a wiring having a high dielectric loss, a high-frequency signal is likely to deteriorate in a transmission path, which may affect high-speed data communication.

In a wiring having a high dielectric loss, there are cases where a signal transmission speed becomes lower. This is because it takes time for a signal to replenish the energy absorbed in the wiring. As the signal delay increases, the reliability of communication decreases.

There are cases where dielectric loss causes a signal to be distorted during transmission. A high dielectric loss affects the amplitude, phase, and waveform of a signal, and impairs the accuracy of the signal.

The bridge wirings 311 electrically connect electronic devices 1 to each other. The bridge wirings 311 are copper wirings, for example.

According to the present embodiment, it is possible to directly exchange power and information between the electronic components 20 placed in the electronic component layer 2, via the bridge wirings 311.

The bridge insulating layers 312 insulate the bridge wirings 311.

As the bridge insulating layers 312 are included, it is possible to suppress the occurrence of short-circuiting between the bridge wirings 311 and the occurrence of short-circuiting between the bridge wirings 311 and the through bridge vias 315.

The bridge insulating layers 312 seal the bridge wirings 311. The bridge insulating layers 312 are formed on the glass base materials 310 on the side of the electronic component layer 2, which is near the second facing portion 313.

In the present embodiment, a plurality of bridge insulating layers 312 is stacked so as to sandwich the bridge wiring 311. Note that each bridge wiring portion may be formed with a multilayer wiring structure including a plurality of layers of bridge wirings 311. In the multilayer wiring structure, a plurality of layers of bridge insulating layers 312 and a plurality of layers of bridge wirings 311 are provided, and the bridge insulating layers 312 and the bridge wirings 311 are alternately stacked. With this arrangement, it is possible to transmit signals between the electronic components 20, using a large number of wirings. Thus, the density of the electronic components 20 and the wirings can be increased. Note that the bridge wirings 311 may be placed directly on the glass base material 310. Alternatively, the bridge wirings 311 may be placed on the outermost surfaces of the bridges 31.

Note that bridge wiring portions formed with the bridge insulating layers 312 and the bridge wirings 311 may also be formed on the glass base material 310 on the side of the wiring layer 4, which is in the vicinity of the third facing portion 314. In this case, a via is formed in each bridge 31, to electrically connect the bridge-side first electrode 316 formed on the second facing portion 313 of the bridge 31 and the bridge wiring 311 formed in the vicinity of the third facing portion 314. With this arrangement, the density of the electronic components 20 and the wirings can also be increased.

Each bridge insulating layer 312 may be an organic insulating layer. As an example, each bridge insulating layer 312 may be a resin material such as a photosensitive resin material or a polyimide resin serving as a non-photosensitive resin material. An organic insulating layer formed with a resin material generally has a low relative permittivity. Accordingly, as an organic insulating layer is used as each bridge insulating layer 312, the dielectric loss can be further reduced. Further, as an organic insulating layer is used, the bridge insulating layer 312 can also be made thicker along with an increase in the thickness of the bridge wiring 311, and, even in this case, the manufacturing cost can be reduced. An increase in the thickness of the bridge wiring 311 is effective in reducing the conductor resistance of the wiring. The organic insulating layer is formed by spin coating, for example. The relative permittivity of the organic insulating layer may be lower than the relative permittivity of silicon. The relative permittivity of the organic insulating layer may be lower than the relative permittivity of the glass material forming the glass base material 310. The relative permittivity of the organic insulating layer is preferably 10 or lower, or more preferably, is 5 or lower.

The bridge insulating layer 312 may be an inorganic insulating layer. The bridge insulating layer 312 may be silicon dioxide (SiO₂), for example. An inorganic insulating layer of silicon dioxide or the like is formed by chemical vapor deposition (CVD), for example.

The second facing portions 313 of the bridges 31 face the first facing portions 200 of the respective electronic components 20. That is, the second facing portions 313 face the first facing portions 200 of the first electronic component 20A, the second electronic component 20B, and the third electronic component 20C. The second facing portions 313 may be the upper surfaces of the bridges 31 in a case where the electronic device 1 illustrated in Fig. 1 is placed on a horizontal plane.

The first facing portions 200 and the second facing portions 313 are electrically connected. Specifically, the first facing portion 200 of the first electronic component 20A is electrically connected to the bridge-side first electrode 316 formed on the second facing portion 313 of the bridge 31 via the bump electrodes 203. The first facing portion 200 of the second electronic component 20B is electrically connected to the bridge-side first electrode 316 formed on the second facing portion 313 of the bridge 31 via the bump electrodes 203. Note that the first facing portion 200 of the first electronic component 20A is electrically connected to the pillar electrodes 320 formed in the facing portion 33 of the connection layer 3 on the side of the electronic component layer 2 via the bump electrodes 202.

The third facing portion 314 of each bridge 31 is formed on the opposite side of the bridge 31 from the second facing portion 313 of the bridge 31. The third facing portion 314 faces the wiring layer 4. Specifically, the third facing portion 314 faces the wiring layer 4 via the insulating layer 30. The third facing portions 314 may be the lower surfaces of the bridges 31 in a case where the electronic device 1 illustrated in Fig. 1 is placed on a horizontal plane.

More specifically, in a case where the electronic device 1 according to the present embodiment is placed on a horizontal plane, each bridge wiring 311 is formed so as to extend in a horizontal direction inside the bridge insulating layer 312, and is further formed so as to be bent toward the electronic component 20 of the electronic component layer 2 at both ends in the horizontal direction and extend until exposed through the second facing portion 313. Here, the horizontal direction is a direction parallel to the surface of the second facing portion 313.

In other words, in a case where the electronic device 1 according to the present embodiment is placed on a horizontal plane, each bridge wiring 311 is formed so as to extend from the vertically lower portion of the first electronic component 20A to the vertically lower portion of the second electronic component 20B inside the bridge insulating layer 312. The bridge wiring 311 is bent at an end portion on the side of the first electronic component 20A, and is formed so as to extend until exposed through the second facing portion 313. The bridge wiring 311 is bent at an end portion on the side of the second electronic component 20B, and is formed so as to extend until exposed through the second facing portion 313.

The electric current and information that are output from the first electronic component 20A are transmitted from the bump electrodes 203 of an electronic-component-side electrode 201 to the bridge wiring 311 via the bridge electrode 3160 (described later) of the bridge-side first electrode 316 formed on the bridge 31 on the side of the first electronic component 20A. The second electronic component 20B receives the electric current and the information, which have been transmitted to the bridge wiring 311, from the bridge electrode 3160 of the bridge-side first electrode 316 formed on the bridge 31 on the side of the second electronic component 20B via the bump electrodes 203 of an electronic-component-side electrode 201 of the second electronic component 20B.

Likewise, the electric current and information that are output from the second electronic component 20B are transmitted from the bump electrodes 203 of an electronic-component-side electrode 201 to the bridge wiring 311 via the bridge electrode 3160 of the bridge-side first electrode 316 formed on the bridge 31 on the side of the second electronic component 20B. The first electronic component 20A receives the electric current and the information, which have been transmitted to the bridge wiring 311, from the bridge electrode 3160 of the bridge-side first electrode 316 formed on the bridge 31 on the side of the first electronic component 20A via the bump electrodes 203 of an electronic-component-side electrode 201 of the first electronic component 20A.

Each through bridge via 315 electrically connects the electronic component layer 2 and the wiring layer 4 directly to each other. The through bridge via 315 is formed so as to penetrate from the second facing portion 313 facing the electronic component layer 2 to the third facing portion 314 facing the wiring layer 4. Each through bridge via 315 is formed in a columnar shape, and a cavity is formed therein. A conductor is formed on the inner peripheral surface of the cavity. The cavity may be filled with a conductor. An example of the conductor is copper formed by a plating technique. The plurality of through bridge vias 315 preferably has a via diameter of 15 µm or smaller, and a pitch that is 25 µm or longer and 100 µm or smaller. In this range, the through bridge vias 315 can easily maintain a high strength while increasing the density of bridges.

Each through bridge via 315 is preferably a linear straight via electrode that penetrates from the second facing portion 313 to the third facing portion 314. That is, each through bridge via 315 is preferably a straight via electrode that linearly penetrates the glass base material 310 and the bridge insulating layer 312. With this arrangement, the wiring length at the time of electrically connecting an electronic component 20 and the wiring layer 4 via a bridge 31 can be shortened. This configuration is particularly effective when HBMs are used as the electronic components 20. In an HBM, the contact points of signal lines are densely placed, and the contact points of power supply lines and the contact points of ground lines are also placed in the vicinity of the contact points of the signal lines. As a specific example, the power supply lines of the electronic components 20 and the power supply lines of the wiring layer 4 are connected via the through bridge vias 315, and thus, the connection distance between them is shortened. Further, the ground lines of the electronic components 20 and the ground lines of the wiring layer 4 are connected via the through bridge vias 315, and thus, the connection distance between them is shortened. In such a case, while the bridge wirings 311 are used as the signal lines to electrically connect the electronic components 20 to each other with a short wiring length, the through bridge vias 315 can also be used as the power supply lines or the ground lines to electrically connect the electronic components 20 and the wiring layer 4 with a short wiring length.

The bridge-side first electrodes 316 are formed on the second facing portions 313. That is, the bridge-side first electrodes 316 are formed on the second facing portions 313 of the bridges 31. The bridge-side first electrodes 316 are electrically connected to the bump electrodes 203 of the electronic components 20 of the electronic component layer 2.

Each bridge-side first electrode 316 includes a bridge electrode 3160 and a via electrode 3161.

The bridge electrode 3160 is formed with, for example, a conductive thin film that extends from the bridge wiring 311 sealed in the bridge insulating layer 312 toward the electronic component 20 and conductively covers an exposed portion as a surface exposed through the second facing portion 313. As an example, the bridge electrode 3160 is formed with copper. Note that the exposed portion of the bridge wiring 311 on the side of the second facing portion 313 may be used as the bridge electrode 3160, without the conductive thin film.

The via electrode 3161 is formed with, for example, a conductive thin film that extends from the through bridge via 315 toward the electronic component 20 and covers an exposed portion as a surface exposed through the third facing portion 314. As an example, the via electrode 3161 is formed with copper. Note that the exposed portion of the bridge wiring 311 on the side of the second facing portion 313 may be used as the via electrode 3161, without the conductive thin film.

The bridge-side second electrodes 317 are formed on the third facing portions 314. That is, the bridge-side second electrodes 317 are formed on the third facing portions 314 of the bridges 31. The bridge-side second electrodes 317 are electrically connected to the third-layer line wiring 46 of the wiring layer 4.

Each bridge-side second electrode 317 includes a via electrode 3170 and a bump electrode 3171. As the structure of the bump electrode 3171, a structure in which a solder material is formed at the end of a copper pillar can be used, and a structure in which the solder contains tin and bismuth can be used in a preferred manner.

The via electrode 3170 is formed with, for example, a conductive thin film that extends from the through bridge via 315 toward the wiring layer 4 and covers an exposed portion as a surface exposed through the third facing portion 314. As an example, the via electrode 3170 is formed with copper. Note that the exposed portion of the bridge wiring 311 on the side of the third facing portion 314 may be used as the via electrode 3170, without the conductive thin film.

The bump electrode 3171 is formed on the via electrode 3170. The bump electrode 3171 is connected to either a power supply line or a ground line of the wiring layer 4.

### <Wiring Layer>

The wiring layer 4 includes the fourth facing portion 40, a fifth facing portion 41, first layer line wirings 42, a first insulating layer 43, second layer line wirings 44, a second insulating layer 45, third layer line wirings 46, first layer via wirings 47, second layer via wirings 48, and bump electrodes 49.

The fourth facing portion 40 faces the third facing portions 314 of the bridges 31. Specifically, the fourth facing portion 40 faces the bridges 31 via the insulating layer 30 of the connection layer 3. The fourth facing portion 40 may be a surface facing the bridges 31. The fourth facing portion 40 may be a surface facing the bridges 31 via the insulating layer 30 of the connection layer 3. The fourth facing portion 40 may be the upper surface of the wiring layer 4 in a case where the electronic device 1 illustrated in Fig. 1 is placed on a horizontal plane.

The fourth facing portion 40 of the wiring layer 4 and the third facing portion 314 of each bridge 31 of the connection layer 3 are electrically connected. Specifically, the third layer line wirings 46 of the fourth facing portion 40 of the wiring layer 4 are electrically connected to the via electrodes 3170 formed in the bridges 31 of the connection layer 3. The via electrode 3170 of the bridge-side second electrode 317 formed on the side of the first electronic component 20A is electrically connected to the corresponding third layer line wiring 46 of the wiring layer 4. The via electrode 3170 of the bridge-side second electrode 317 formed on the side of the second electronic component 20B is electrically connected to the corresponding third layer line wiring 46 of the wiring layer 4. At this point of time, the bridges 31 are metal-joined to the wiring layer 4 by flip-chip mounting. This allows the bridges 31 to be mounted with a very high positioning accuracy.

The fifth facing portion 41 is formed on the opposite side of the wiring layer 4 from the fourth facing portion 40 of the wiring layer 4. The fifth facing portion 41 faces the substrate 5. Specifically, the fifth facing portion 41 faces the substrate 5 via the bump electrodes 49 formed on the fifth facing portion 41. The fifth facing portion 41 may be the lower surface of the wiring layer 4 in a case where the electronic device 1 illustrated in Fig. 1 is placed on a horizontal plane.

The first layer line wirings 42 are formed on the fifth facing portion 41 of the wiring layer 4. As an example, the first layer line wirings 42 can be formed with copper wirings.

The first insulating layer 43 insulates the first layer line wirings 42, the first layer via wirings 47, and the second layer line wirings 44. The first insulating layer 43 is formed on the first layer line wirings 42 in a case where the electronic device 1 illustrated in Fig. 1 is placed on a horizontal plane. As an example, the first insulating layer 43 can be formed with a resin such as polyimide, polybenzoxazole, or benzocyclobutene. In a case where these resins have a photosensitive function, the wiring layers formed on and under the resin material can be electrically connected by providing vias (openings) and filling the vias with a conductive material such as a metal by a photolithographic technique. In a case where the resin material is not photosensitive, vias can be opened by laser light irradiation or dry etching.

The second layer line wirings 44 are stacked on the opposite side of the first insulating layer 43 from the first layer line wirings 42. The second layer line wirings 44 are formed to increase the density of the electronic components 20 and the wirings in a case where the plurality of electronic components 20 is mounted in the electronic device 1 according to the present embodiment. The second layer line wirings 44 are stacked on the first insulating layer 43 in a case where the electronic device 1 illustrated in Fig. 1 is placed on a horizontal plane. The second layer line wirings 44 can be formed with the same composition as the first layer line wirings 42.

The second insulating layer 45 insulates the second layer line wirings 44, the second layer via wirings 48, and the third layer line wirings 46. The second insulating layer 45 is stacked on the second layer line wirings 44 in a case where the electronic device 1 illustrated in Fig. 1 is placed on a horizontal plane. The second insulating layer 45 can be formed with the same composition as the first insulating layer 43.

The third layer line wirings 46 are formed on the fourth facing portion 40 of the wiring layer 4. In a case where the connection layer 3 and the wiring layer 4 are joined to each other, the third layer line wirings 46 are electrically connected to the exposed portions of the pillars 32 formed in the connection layer 3 on the side of the wiring layer 4. In a case where the connection layer 3 and the wiring layer 4 are joined to each other, the third layer line wirings 46 are electrically connected to the bridge-side second electrodes 317 of the bridges 31. The third layer line wirings 46 are stacked on the second insulating layer 45 in a case where the electronic device 1 illustrated in Fig. 1 is placed on a horizontal plane. The third layer line wirings 46 can be formed with the same composition as the first layer line wirings 42 and the second layer line wirings 44.

The first layer via wirings 47 electrically connect the first layer line wirings 42 and the second layer line wirings 44. In a case where the electronic device 1 illustrated in Fig. 1 is placed on a horizontal plane, the first layer via wirings 47 are formed to extend from the first layer line wirings 42 to the second layer line wirings 44 in the vertical direction.

The second layer via wirings 48 electrically connect the second layer line wirings 44 and the third layer line wirings 46. In a case where the electronic device 1 illustrated in Fig. 1 is placed on a horizontal plane, the second layer via wirings 48 are formed to extend from the second layer line wirings 44 to the third layer line wirings 46 in the vertical direction.

The bump electrodes 49 electrically connect the wiring layer 4 and the substrate 5. In a case where the wiring layer 4 and the substrate 5 are connected, the bump electrodes 49 electrically connect the first layer line wirings 42 of the wiring layer 4 and wirings (not illustrated) of the substrate 5. The bump electrodes 49 are formed on the fifth facing portion 41.

### <Stacking of Electronic Components and Bridges>

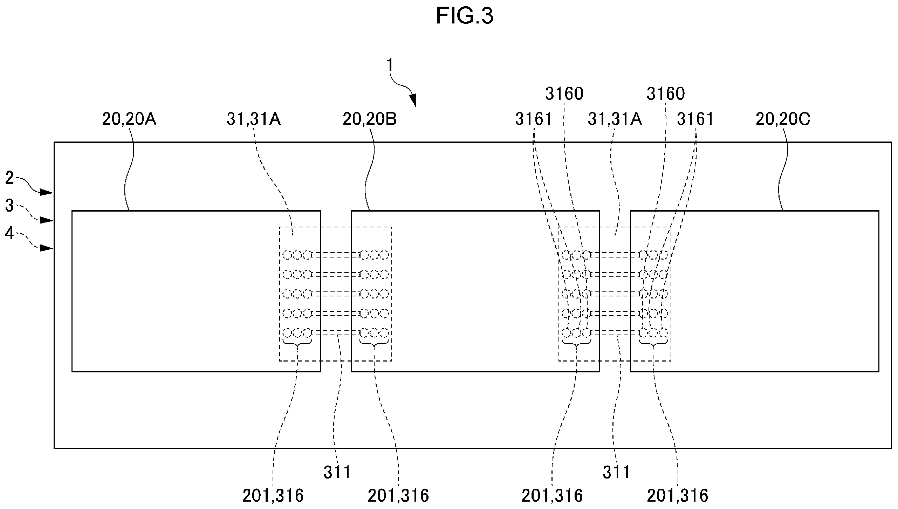

In the following, the description of the electronic device 1 according to the present embodiment continues with reference to Fig. 3, in addition to Figs. 1 and 2. Fig. 3 is an external view of the electronic device 1 according to the present embodiment as viewed from above.

Fig. 3 illustrates the first electronic component 20A, the second electronic component 20B, the third electronic component 20C, the first bridge 31A, and the second bridge 31B included in the electronic device 1 according to the present embodiment.

As illustrated in Fig. 3, when the electronic device 1 according to the present embodiment is placed on a horizontal plane, and the electronic component layer 2 and the connection layer 3 are viewed from the stacking direction, each bridge 31 is placed so as to overlap a plurality of electronic components 20.

According to the present embodiment, the electronic components 20 can be densely placed in the electronic component layer 2. Accordingly, in the electronic device 1 having specified dimensions, the amount of information that can be processed by the electronic components 20 can be increased.

In other words, in a case where the electronic device 1 according to the present embodiment is placed on a horizontal plane and is viewed from above in the vertical direction, part of the first electronic component 20A and part of the first bridge 31A overlap. Likewise, part of the second electronic component 20B and part of the first bridge 31A overlap. Likewise, part of the second electronic component 20B and part of the second bridge 31B overlap. Likewise, part of the third electronic component 20C and part of the second bridge 31B overlap.

More specifically, as illustrated in Fig. 2, in a case where the electronic device 1 according to the present embodiment is placed on a horizontal plane and is viewed from above in the vertical direction, the electronic-component-side electrodes 201 of the first electronic component 20A and the bridge-side first electrodes 316 of the first bridge 31A overlap. Likewise, the electronic-component-side electrodes 201 of the second electronic component 20B and the bridge-side first electrodes 316 of the first bridge 31A overlap. Likewise, the electronic-component-side electrodes 201 of the second electronic component 20B and the bridge-side first electrodes 316 of the second bridge overlap. Likewise, the electronic-component-side electrodes 201 of the third electronic component 20C and the bridge-side first electrodes 316 of the second bridge 31B overlap. The same applies hereinafter.

With such a configuration, when the electronic component layer 2 and the connection layer 3 are joined to each other as shown in Fig. 1, the bump electrodes 203 of the electronic-component-side electrode 201 of the first electronic component 20A are electrically connected to the bridge electrodes 3160 and the via electrodes 3161 of the bridge-side first electrodes 316 of the first bridge 31A. Likewise, the bump electrodes 203 of the electronic-component-side electrodes 201 of second electronic component 20B are electrically connected to the bridge electrodes 3160 and the via electrodes 3161 of the bridge-side first electrodes 316 of the first bridge 31A.

Solder can be used for connection between the electronic components 20 and the electrodes of the connection layer 3. The solder preferably contains silver, the principal component being tin. In a case where the electronic components are connected to the connection layer 3 after the bridges are connected to the wiring layer 4, the solder connecting portions between the bridges and the wiring layer 4 are also heated to some extent in the process of connecting the electronic components to the connection layer 3. At this point of time, if the solder connecting the bridges and the wiring layer 4 melts, the bridges are misaligned in some cases. The composition of the solder connecting the bridges and the wiring layer contains tin and bismuth, and this portion is converted into an intermetallic compound after the solder connection, so that the melting point of the portion can be made much higher than the melting point of the solder containing silver with the principal component being tin. With this arrangement, when the electronic components are connected to the connection layer 3 with solder, the solder connecting the bridges and the wiring layer 4 does not melt, and the bridge mounting accuracy is not adversely affected, which is preferable.

The bridges 31 may be smaller than any of the electronic components 20 to be connected to the bridges. Specifically, the first bridge 31A is smaller than the first electronic component 20A, and is smaller than the second electronic component 20B. For example, when the electronic device 1 according to the present embodiment is placed on a horizontal plane, and the electronic component layer 2 and the connection layer 3 are viewed from the stacking direction, the area of the first bridge 31A is smaller than the area of the first electronic component 20A and the area of the second electronic component 20B. That is, the area of the first bridge 31A in a planar view is smaller than both the area of the first electronic component 20A and the area of the second electronic component 20B in a planar view.

According to the present embodiment, the proportion occupied by the bridges 31 using the glass base material 310 in the wiring layer 4 can be reduced, and thus, the increase in cost can be reduced.

### <Bridge Manufacturing Step>

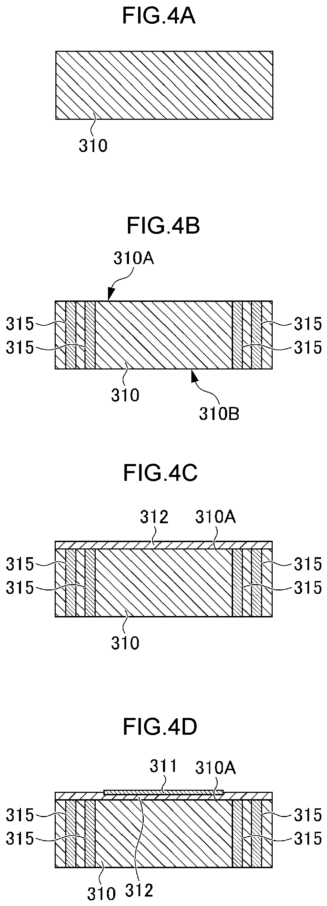

Next, a process of manufacturing the electronic device 1 according to the present embodiment is described with reference to Figs. 4A to 4H. Figs. 4A to 4H are drawings illustrating the step of manufacturing the bridges 31 of the electronic device 1 according to the embodiment.

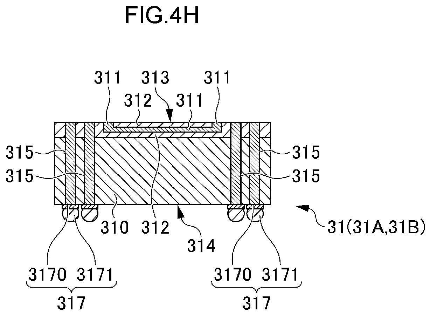

Fig. 4A is a drawing illustrating a glass base preparing step of preparing the glass base material 310. As illustrated in Fig. 4A, first, the glass base material 310 is prepared. The glass base material 310 is a glass wafer, for example. Note that, in practice, after the steps up to the step illustrated in Fig. 4H are completed, the resultant material is cut into chips each having the size of one bridge 31 by dicing. However, in Figs. 4A to 4H, the glass base material 310 having the size of one bridge 31 is illustrated, for ease of explanation.

Fig. 4B is a drawing illustrating a via filling step of forming part of the through bridge vias 315 by performing via filling on the formed through-holes after the through-hole forming step of forming the through-holes in the glass base material 310. As illustrated in Fig. 4B, through-holes are formed so as to penetrate from a first principal surface 310A to a second principal surface 310B (the third facing portion 314 of the bridge 31) of the glass base material 310. The through-holes are formed by laser processing, for example. It is also preferable to smooth the surfaces of the through-holes by etching with hydrofluoric acid after the laser processing. In the through-holes, after a seed layer is formed by sputtering film formation, electroless plating, or the like, a metal layer such as a copper layer is formed on the seed layer by electroplating, and a conductive treatment for lowering resistance is performed. The metal layer may be formed only on the inner wall surfaces of the through-holes, or the entire holes may be filled with metal. Thus, via electrodes as at least part of the through bridge vias 315 are formed.

Fig. 4C is a drawing illustrating an insulating film forming step of forming the bridge insulating layer 312 on the first principal surface 310A of the glass base material 310. As illustrated in Fig. 4C, the bridge insulating layer 312 is formed on the first principal surface 310A of the glass base material 310. The bridge insulating layer 312 is formed with an organic insulating layer formed by spin coating, for example. As the organic insulating film layer material, polyimide, polybenzoxazole, benzocyclobutene, or the like can be used. Alternatively, the bridge insulating layer 312 is formed with an inorganic insulating layer such as a SiO₂ layer formed by CVD or the like.

Fig. 4D is a drawing illustrating a bridge wiring forming step of forming the bridge wiring 311 on the bridge insulating layer 312. As illustrated in Fig. 4D, the bridge wiring 311 is further formed on the bridge insulating layer 312 on the side of the first principal surface 310A of the glass base material 310. As an example, the bridge wiring 311 is formed by an additive method. By the additive method, for example, a resist is formed on the bridge insulating layer 312, and the bridge wiring 311 is then formed by electroless plating (a full-additive method). As another method, it is possible to use a method (a semi-additive method) by which a seed layer formed with titanium or copper is formed by a sputtering technique, a wiring pattern is formed with a resist, a metal wiring formed with copper or the like is formed by electrolytic plating, the resist is removed, and the seed layer between the wirings is removed by etching, to form the wirings. It is also possible to use a damascene process. As the bridge wirings 311, copper wirings are used, for example.

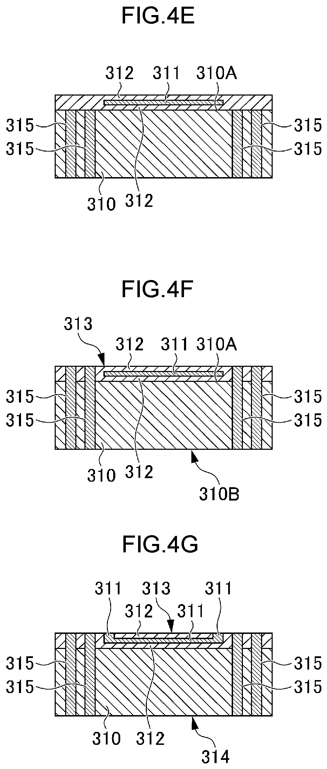

Fig. 4E is a drawing illustrating an insulating film forming step of forming the bridge insulating layer 312 on the bridge wiring 311. As illustrated in Fig. 4E, the bridge insulating layer 312 is further formed on the bridge wiring 311 stacked on the bridge insulating layer 312, and the bridge wiring 311 is sealed with the bridge insulating layer 312. Note that the step in Fig. 4D and the step in Fig. 4E may be repeated to form the bridge wiring portion as a multilayer wiring structure having a plurality of layers of bridge wirings 311. In this case, the bridge wiring portion includes a plurality of layers of bridge insulating layers 312 and a plurality of layers of bridge wirings 311, and the bridge insulating layers 312 and the bridge wirings 311 are alternately stacked therein. With this arrangement, it is possible to transmit signals between the electronic components 20, using a large number of wirings.

In a bridge wiring, when the number of signal lines between electronic components interconnected by the bridge wiring becomes larger, the wiring width becomes smaller, or the number of wiring layers becomes larger. For example, in a case where the width of the wiring of each bridge wiring and the intervals between the wirings are both 2 µm, and, in a case with 1024 bits, the number of bridge wiring layers may be six or larger.

Fig. 4F is a drawing illustrating a via filling step of forming the through bridge vias 315 by performing via filling on the formed openings after an opening forming step of forming the openings in the bridge insulating layer 312. In a case where the resin material that forms the bridge insulating layer 312 has a photosensitive function, vias (openings) are formed by a photolithographic technique, and are filled with a conductive material such as a metal. The conductive material is connected to via electrodes (not shown) of the glass base material 310, to form the through bridge vias 315. Note that, in a case where the resin material is not photosensitive, vias can be opened by laser light irradiation or dry etching. As an example, after vias (openings) are formed, a seed layer is first formed on the inner surfaces of the vias by sputtering. As the seed layer, for example, a titanium film is used. After that, via filling is performed by electrolytic plating, and thus, the through bridge vias 315 are formed. The via electrodes as the through bridge vias 315 are formed with copper, for example. Note that, after this, the surface of the bridge 31 is polished by CMP, and the extra metal portion formed during the via filling step is removed. The surface polished by CMP on the side of the first principal surface 310A then serves as the second facing portion 313 of the bridge 31. Note that the second principal surface 310B of the glass base material 310 serves as the third facing portion 314 of the bridge 31.

Fig. 4G is a drawing illustrating a bridge wiring forming step. As illustrated in Fig. 4G, the bridge wiring 311 is additionally formed so that the bridge wiring 311 is exposed through the second facing portion 313. The wiring to be additionally formed is formed by a damascene method or a semi-additive method. As a result, the bridge wiring 311 that is bent at both ends in the horizontal direction and whose ends are exposed through the second facing portion 313 is formed.

Fig. 4H is a drawing illustrating a bump electrode forming step. As illustrated in Fig. 4H, the bridge-side second electrodes 317 are formed on the through bridge vias 315 on the side of the third facing portion 314. That is, the via electrodes 3170 as a seed layer are formed on the exposed portions of the through bridge vias 315 on the side of the third facing portion 314, and the bump electrodes 3171 are further formed on the via electrodes 3170. Note that the formation of the seed layer may be skipped. After that, the resultant material is cut into bridges each having the chip size by dicing, to complete the bridges 31 on which bump electrodes are formed.

### <Stacking Process in Electronic Device>

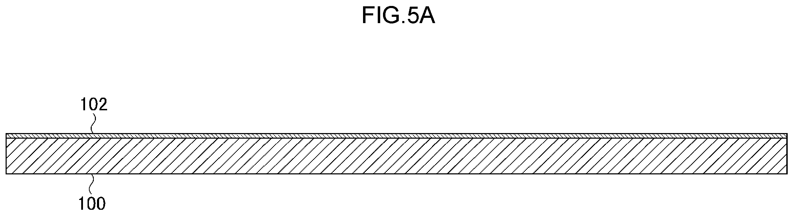

Next, a stacking process in the electronic device 1 according to an embodiment is described with reference to Figs. 5A to 5O. Figs. 5A to 5O are drawings illustrating the stacking process in the electronic device 1 according to an embodiment.

Fig. 5A is a drawing illustrating a release layer forming step of forming a release layer 102 on a panel carrier 100 prepared in a panel carrier preparing step. As illustrated in Fig. 5A, the release layer 102 is formed on the panel carrier 100 serving as the base. As the material of the panel carrier, glass, ceramics such as alumina, silicon, or the like can be preferably used. A glass carrier is preferable, because the range of warpage during the process can be kept within a certain range with the use of a glass carrier having an appropriate linear expansion coefficient among a rich variation of linear expansion coefficients. A ceramic carrier has a high elastic modulus, and accordingly, the warpage after wiring layer formation and after molded material formation is easily reduced, which is preferable. Having a high elastic modulus, a silicon carrier is effective in reducing warpage during the process, and it is easy to increase the flatness and smoothness of the surface thereof. Accordingly, fine wirings can be easily formed thereon, which is preferable.

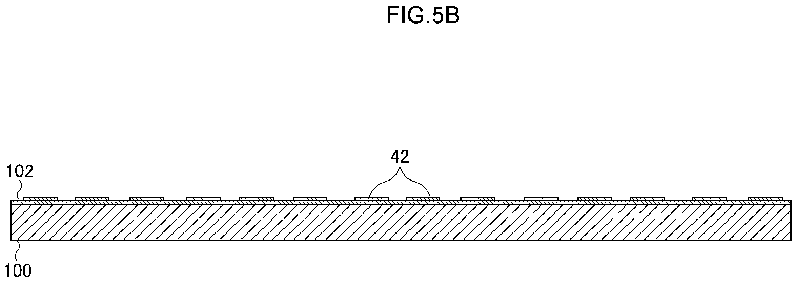

Fig. 5B is a drawing illustrating a wiring forming step of forming the first layer line wirings 42 on the release layer 102. As illustrated in Fig. 5B, a copper layer is formed on the release layer 102, to form the first layer line wirings 42. The patterned first layer line wirings 42 are formed by a damascene method or a semi-additive method, for example.

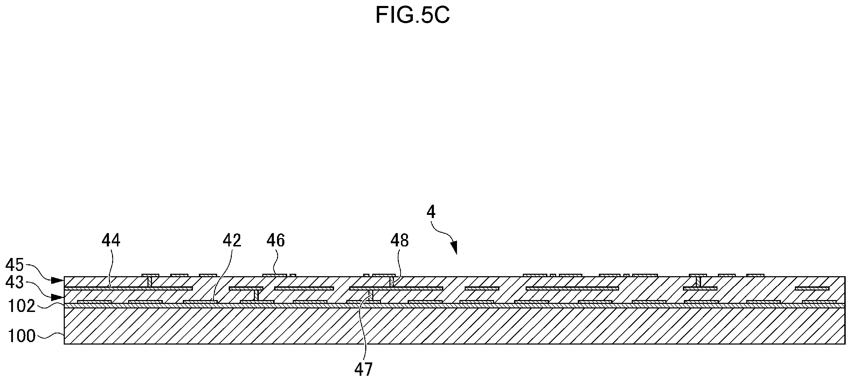

Fig. 5C is a drawing illustrating a wiring layer forming step of forming the wiring layer 4 on the release layer 102. As illustrated in Fig. 5C, the wiring layer 4 is stacked on the release layer 102.

As an example, the wiring layer 4 is formed by stacking the first insulating layer 43, the second layer line wirings 44, the second insulating layer 45, and the third layer line wirings 46 in this order over the first layer line wirings 42. The first layer via wirings 47 may be formed after the first insulating layer 43 is formed. The second layer via wirings 48 may be formed after the second insulating layer 45 is formed.

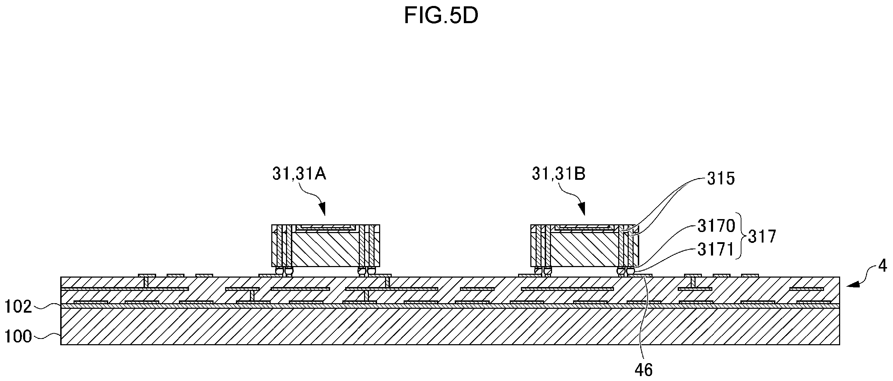

Fig. 5D is a drawing illustrating a bridge mounting step of mounting the bridges 31 on the wiring layer 4. As illustrated in Fig. 5D, the bridges 31 (the first bridge 31A and the second bridge 31B) prepared by the steps illustrated in Figs. 4A to 4H are mounted on the wiring layer 4. At this point of time, the bridges 31 are metal-joined to the wiring layer 4 by flip-chip mounting. More specifically, the bridge-side second electrodes 317 of the bridges 31 are metal-joined to the contact portions of the third layer line wirings 46 of the wiring layer 4. This allows the bridges 31 to be mounted with a very high positioning accuracy.

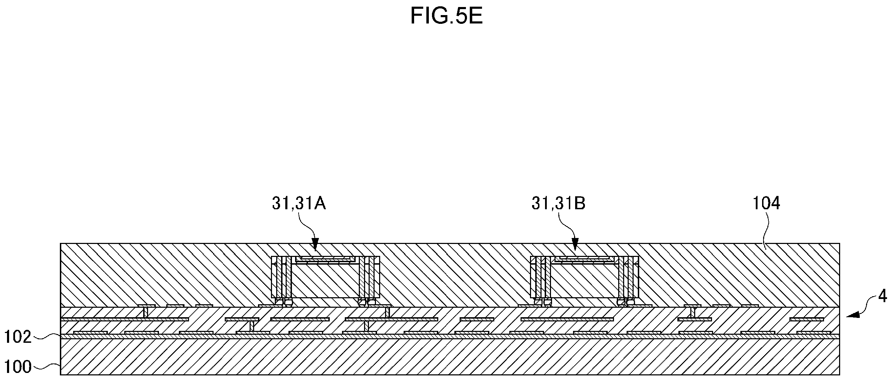

Fig. 5E is a drawing illustrating a resist film forming step as part of a pillar forming step. As illustrated in Fig. 5E, a thick resist film 104 is formed so as to cover the bridges 31 (the first bridge 31A and the second bridge 31B).

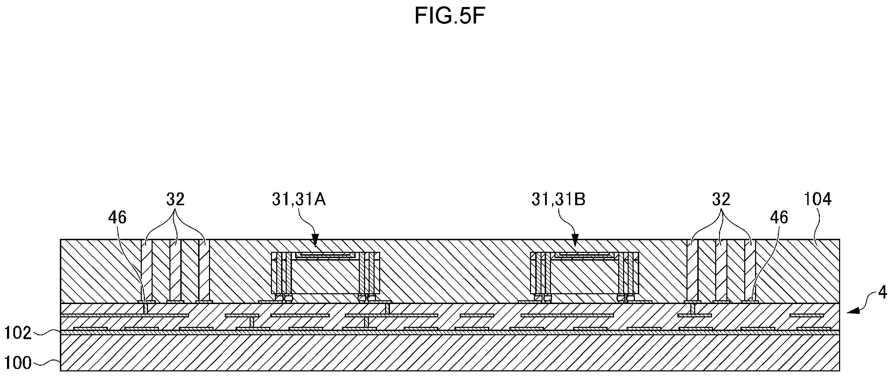

Fig. 5F is a drawing illustrating a pillar forming step of forming the pillars 32 by performing via filling on the formed holes after a hole forming step of forming holes in the resist film 104. As illustrated in Fig. 5F, etching is performed on predetermined portions (the contact portions of the third layer line wirings 46) of the resist film 104 to form holes, and via filling is then performed on the formed holes by electrolytic plating, to form the pillars 32. As an example of the via filling, a seed layer is first formed on the inner surface of each hole by sputtering. As the seed layer, for example, a titanium film is used. After that, via filling is performed by electrolytic plating, and thus, the pillars 32 are formed. The metal pillars as the pillars 32 are formed with copper, for example.

Regarding the order of the bridge mounting and the pillar formation, the pillar formation may be performed on the wiring layer 4 before the bridge mounting, by performing resist coating, hole formation and processing on the resist by lithography or the like, seed layer formation by sputtering, pillar formation by electrolytic plating, and resist removal in this order. After that, the bridges and the like may be mounted.

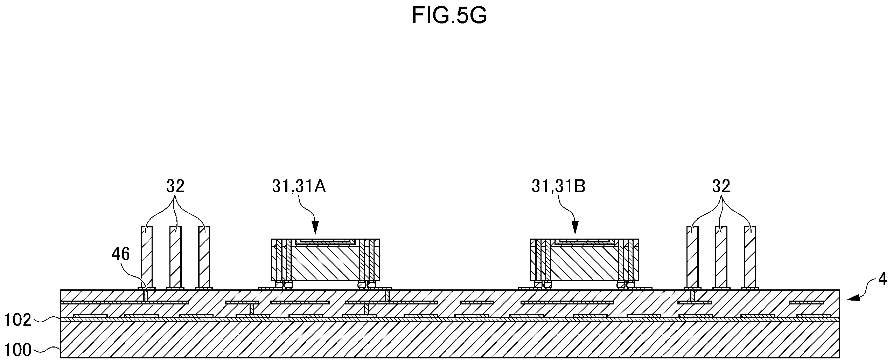

Fig. 5G is a drawing illustrating a resist film removing step of removing the resist film 104. As illustrated in Fig. 5G, the resist film 104 is removed to expose the bridges 31 (the first bridge 31A and the second bridge 31B) and the pillars 32.

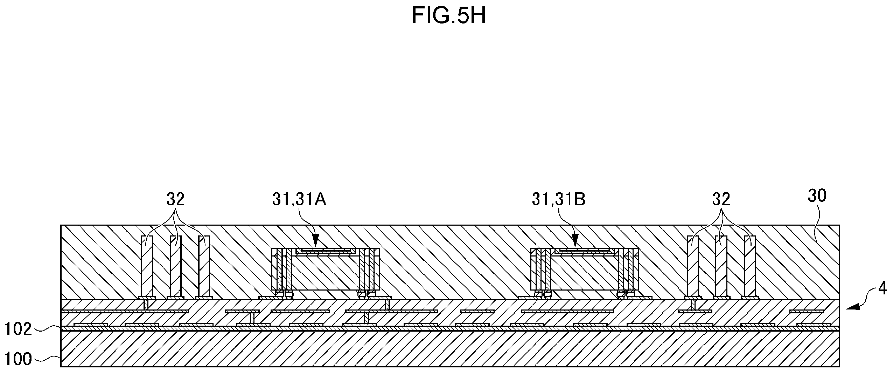

Fig. 5H is a drawing illustrating a molding step of covering the bridges 31 and the pillars 32 with the insulating layer 30. As illustrated in Fig. 5H, the bridges 31 (the first bridge 31A and the second bridge 31B) and the pillars 32 are molded with the insulating layer 30. Before molding is performed with the insulating layer 30, the spaces between the bridges 31 and the wiring layer 4 may be sealed with a capillary flow underfill material, and molding may be performed after that. However, it is preferable to perform a mold underfill step of collectively sealing the spaces between the bridges 31 and the wiring layer 4 in the molding step of covering the peripheries of the bridges, because the processing is simpler.

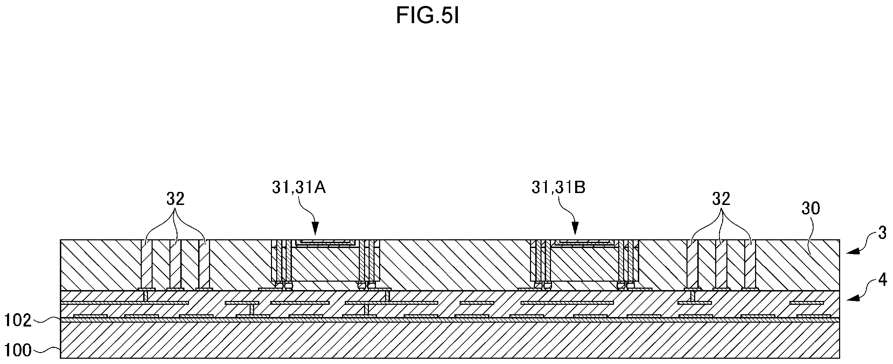

Fig. 5I is a drawing illustrating a grinding step of grinding the surface of the insulating layer 30. As illustrated in Fig. 5I, the surface of the insulating layer 30 is ground with a grinder or the like, to expose the second facing portions 313 of the bridges 31. At this point of time, the pillars 32 are also ground, to form the exposed portions of the pillars 32 on the side of the facing portion 33 of the connection layer 3 on the side of the electronic component layer 2.

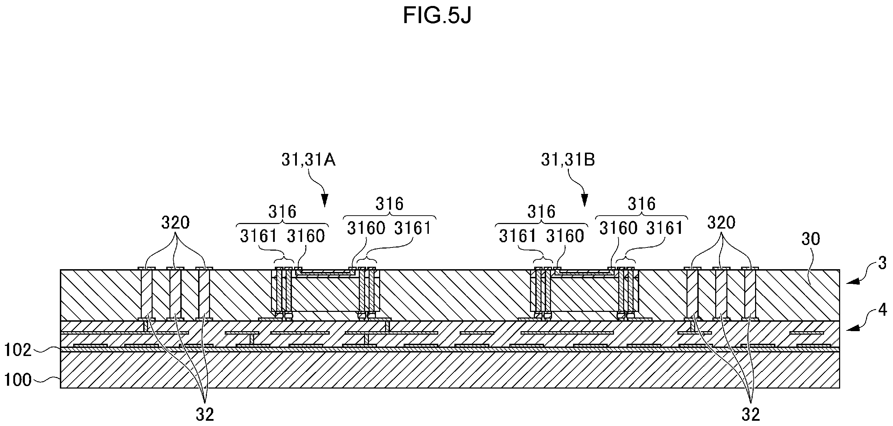

Fig. 5J is a drawing illustrating an electrode forming step of forming electrodes with thin metal films. As illustrated in Fig. 5J, the bridge electrodes 3160 formed with thin metal films are formed on the surfaces of the bridge wirings 311 exposed through the second facing portions 313 of the bridges 31 (the first bridge 31A and the second bridge 31B), and the via electrodes 3161 formed with thin metal films are formed on the surfaces of the through bridge vias 315. Further, the pillar electrodes 320 formed with thin metal films are formed on the surfaces of the pillars 32. However, this step is not necessarily performed, and the exposed surfaces of the bridge wirings 311, the surfaces of the through bridge vias 315, and the surfaces of the pillars 32 may be used as the electrodes. In this manner, the connection layer 3 is formed.

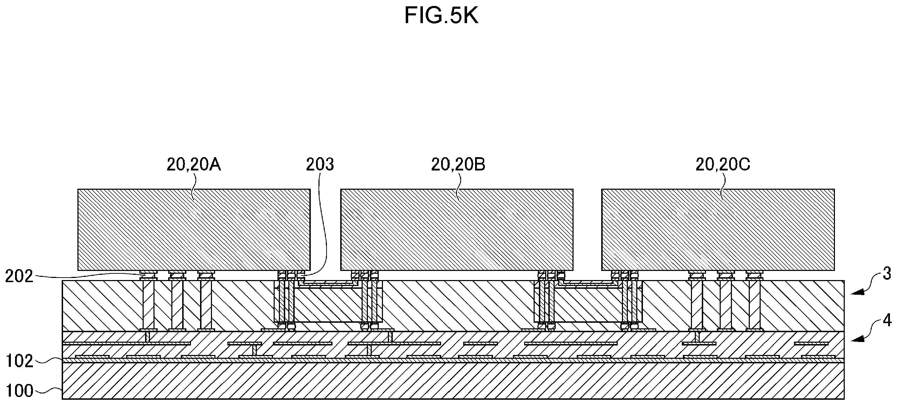

Fig. 5K is a drawing illustrating an electronic component mounting step of mounting the electronic components 20 on the connection layer 3. As illustrated in Fig. 5K, the electronic components 20 (the first electronic component 20A, the second electronic component 20B, and the third electronic component 20C) are mounted on the connection layer 3 so as to partially overlap the bridges 31 (the first bridge 31A and the second bridge 31B). Specifically, the bump electrodes 203 and bump electrodes 202 of the electronic components 20 (the first electronic component 20A, the second electronic component 20B, and the third electronic component 20C) are joined to the bridges 31 (the first bridge 31A and the second bridge 31B) and the pillars 32. At this point of time, the electronic components 20 are metal-joined to the connection layer 3 by flip-chip mounting. This allows the electronic components 20 to be mounted with a very high positioning accuracy.

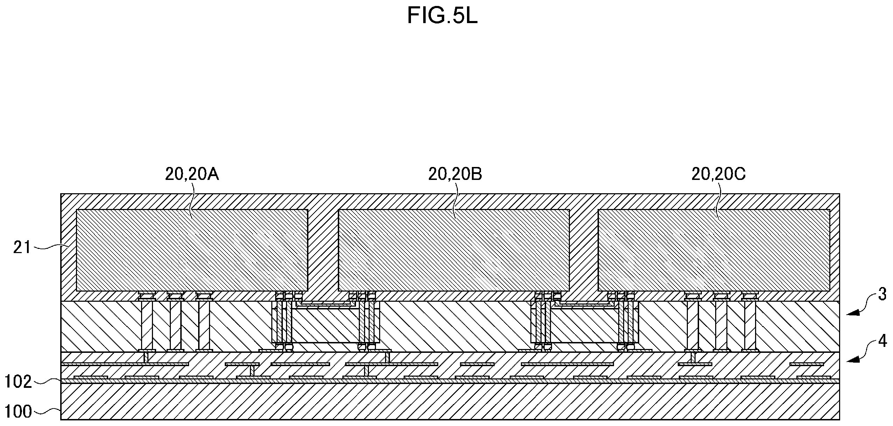

Fig. 5L is a drawing illustrating a molding step of covering the electronic components 20 with the insulating layer 21. As illustrated in Fig. 5L, the electronic components 20 (the first electronic component 20A, the second electronic component 20B, and the third electronic component 20C) are molded with the insulating layer 21.

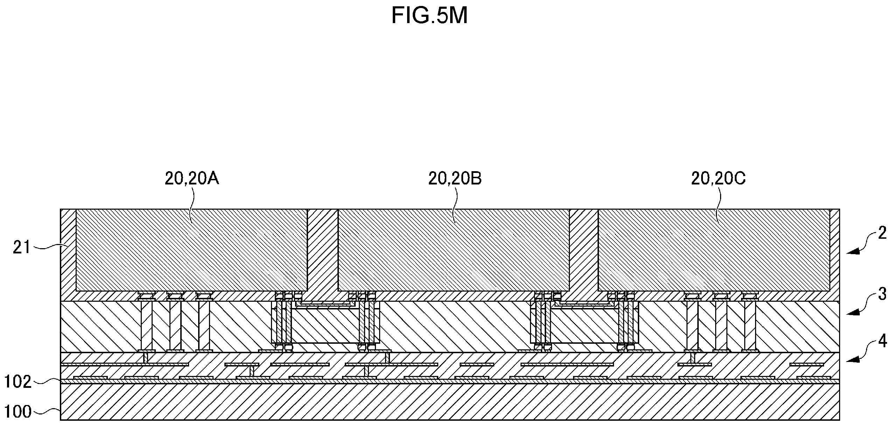

Fig. 5M is a drawing illustrating a grinding step of grinding the surface of the insulating layer 21. As illustrated in Fig. 5M, the insulating layer 21 is ground with a grinder or the like, to expose the surfaces of the electronic components 20 (the first electronic component 20A, the second electronic component 20B, and the third electronic component 20C). This step is not necessarily performed, but is useful in a case where a heat dissipation structure is formed directly on the electronic components 20 to dissipate heat.

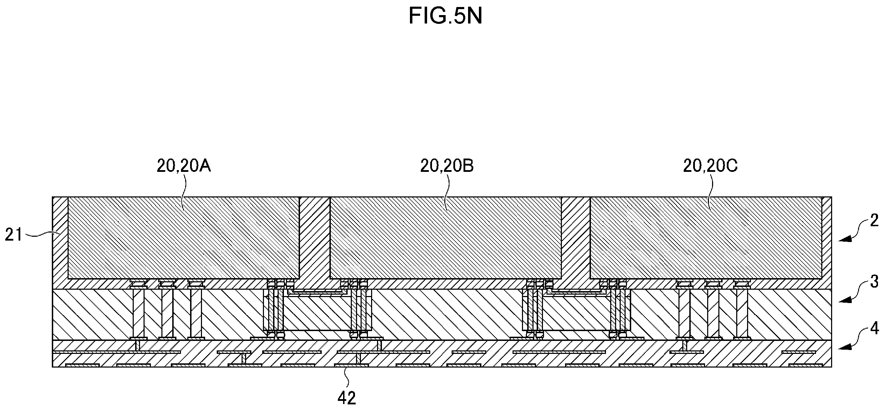

Fig. 5N is a drawing illustrating a panel carrier removing step of removing the panel carrier 100. As illustrated in Fig. 5N, the panel carrier 100 and the release layer 102 are removed.

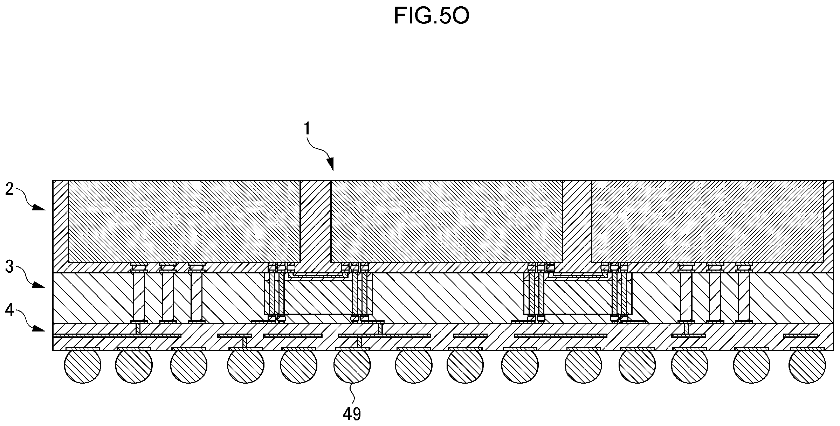

Fig. 5O is a drawing illustrating a bump electrode forming step of forming the bump electrodes 49 on the wiring layer 4. As illustrated in Fig. 5O, the bump electrodes 49 are formed on the first layer line wirings 42 of the wiring layer 4. Thus, the electronic device 1 is completed. After that, the electronic device 1 is mounted on the substrate 5, using the bump electrodes 49.

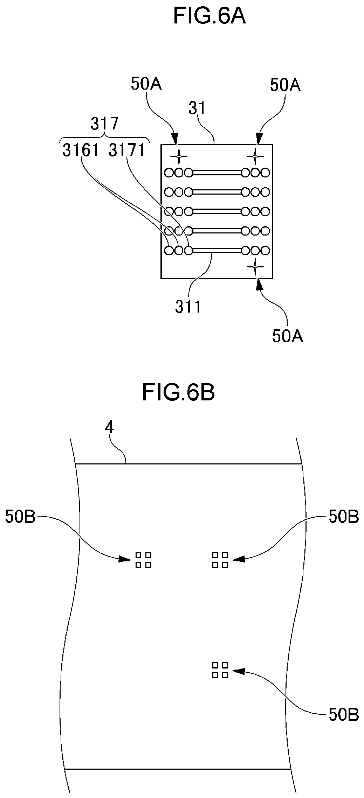

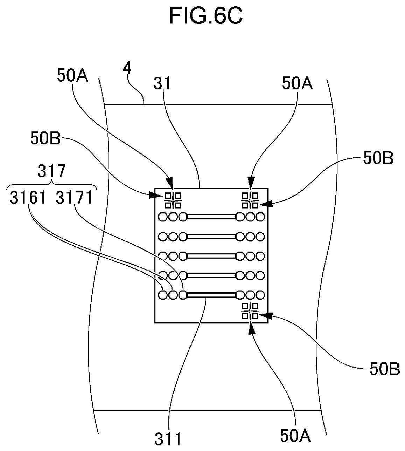

Next, Figs. 6A to 6C illustrate a modification of the present embodiment. Fig. 6A is an external view of a bridge 31 according to the modification as viewed from above (a planar view). Fig. 6B is an external view of the wiring layer 4 as viewed from above (a planar view). Fig. 6C is a drawing illustrating an alignment step in the bridge mounting step of mounting the bridges 31 on the wiring layer 4. Note that, in Figs. 6B and 6C, the third layer line wirings 46 are not shown.

As illustrated in Fig. 6A, a bridge 31 has first alignment marks 50A as alignment marks.

In the present modification, the first alignment marks 50A are placed near the second facing portion 313 (see Fig. 4H). The first alignment marks 50A are placed in the bridge insulating layer 312, for example. Specifically, the first alignment marks 50A may be placed in the same layer as the layer in which the bridge wirings 311 are placed. The first alignment marks 50A may be formed with the same material as the bridge wirings 311. This facilitates the step of forming the alignment marks. Note that the first alignment marks 50A may be placed in a different layer from the layer in which the bridge wirings 311 are placed. The first alignment marks 50A may be formed with a different material from the bridge wirings 311.

The first alignment marks 50A are placed apart from the bridge wirings 311 in the same layer as the layer in which the bridge wirings 311 are placed. As described above, the first alignment marks 50A are provided separately from the bridge wirings 311, and thus, alignment can be performed more accurately. Note that part of the bridge wirings 311 may also serve as the first alignment marks 50A.

The first alignment marks 50A have a shape that matches the shape of second alignment marks 50B placed in the wiring layer 4 as described later. The first alignment marks 50A are cross-shaped marks, for example. However, the shape is not limited to this.

A plurality of the first alignment marks 50A is preferably provided, and more preferably, three or more first alignment marks 50A are provided. In the present modification, three first alignment marks 50A are provided.

Note that the first alignment marks 50A may be placed on the surface of the second facing portion 313 (see Fig. 4H). The first alignment marks 50A may be placed on the bridge insulating layer 312. Alternatively, the first alignment marks 50A may be placed on the glass base material 310 on the side of the second facing portion 313.

Note that the first alignment marks 50A may be placed near the third facing portion 314 (see Fig. 4H). The first alignment marks 50A placed near the third facing portion 314 can be recognized by a camera through the glass base material 310. Note that the first alignment marks 50A may be placed on the surface of the third facing portion 314. Alternatively, the first alignment marks 50A may be placed on the glass base material 310 on the side of the third facing portion 314. Note that, in a case where a translucent insulating layer is placed on the side of the third facing portion 314, the first alignment marks 50A may be placed on the translucent insulating layer. In a case where the first alignment marks 50A are placed near the third facing portion 314, the distance from the second alignment marks 50B described later is short, and accordingly, the alignment accuracy can be increased.

As illustrated in Fig. 6B, the wiring layer 4 has the second alignment marks 50B. The second alignment marks 50B are provided on the surface of the wiring layer 4. The second alignment marks 50B may be formed with the same material as the third layer line wirings 46. This facilitates the step of forming the alignment marks. Note that the second alignment marks 50B may be formed with a different material from the third layer line wirings 46.

The second alignment marks 50B have a shape that matches the shape of the first alignment marks 50A. The second alignment marks 50B are marks each including four quadrangles, for example. However, the shape is not limited to this.

A plurality of the second alignment marks 50B is preferably provided, and more preferably, three or more second alignment marks 50B are provided. In the present modification, three second alignment marks 50B are provided. The number of the second alignment marks 50B provided is the same as the number of the first alignment marks 50A.

In the present modification, an alignment step using the alignment marks is performed in the bridge mounting step illustrated in Fig. 5D. Fig. 6C is a diagram for explaining the alignment step when the bridges 31 are flip-chip mounted on the wiring layer 4. Fig. 6C is a top view of the wiring layer 4 and a bridge 31 disposed on the wiring layer 4. Specifically, this is Fig. 5D viewed from the top side to the bottom side of the drawing.

At least part of the bridge 31 is formed with a member capable of transmitting light from the second facing portion 313 to the third facing portion 314. The glass base material 310 of the bridge 31 is a translucent member. In the present modification, the bridge insulating layer 312 is formed with a translucent material. Specifically, the bridge insulating layer 312 is preferably formed with a translucent resin material or a translucent inorganic material. The translucent resin material is not limited to any particular material as long as it has translucency, and epoxy, polyimide, polybenzoxazole, benzocyclobutene, or the like can be used. Particles may be dispersed in these resins as long as translucency is secured. The material of the particles is not limited to any particular material, and silica, alumina, barium sulfate, talc, aluminum nitride, silicon nitride, silicon carbide, or the like can be used. The translucent inorganic material is not limited to any particular material, and, for example, silicon oxide, silicon nitride, silicon carbonitride, aluminum oxide, or the like can be used. In the present modification, the surface of the wiring layer 4 can be checked through the bridge 31, except for the portions of the wirings such as the bridge wirings 311 provided in the bridge 31.

The second alignment marks 50B placed on the wiring layer 4 can be checked with a camera through the bridge 31. Further, in a case where the first alignment marks 50A are placed near the third facing portion 314, the first alignment marks 50A placed near the third facing portion 314 can also be checked with a camera through the glass base material 310 of the bridge 31.

As illustrated in Fig. 6C, as the first alignment marks 50A of the bridge 31 and the second alignment marks 50B of the wiring layer 4 are aligned, the position and the rotating direction of the bridge 31 on the wiring layer 4 are accurately aligned. After the first alignment marks 50A and the second alignment marks 50B are aligned, flip-chip mounting is performed. In the present modification, as flip-chip mounting by metal joining can be performed after accurate alignment, the bridge 31 can be mounted with a higher positional accuracy.

A plurality of the first alignment marks 50A and a plurality of the second alignment marks 50B are preferably provided, so as to accurately align the position and the rotating direction of the bridge 31 on the wiring layer 4. More preferably, three or more first alignment marks 50A and three or more second alignment marks 50B are provided. A plurality of the first alignment marks 50A is preferably placed near the outer periphery of the bridge 31 in a planar view. In a case where the shape of the bridge 31 is a quadrangular shape in a planar view, the alignment marks are preferably provided at two or more, or preferably three or more, of the four corners of the quadrangle.

As described above, it is preferable that the first alignment marks 50A as the alignment marks are formed on the glass bridge 31 formed with a glass base material. The first alignment marks 50A may be formed on either the side of the second facing portion 313 or the side of the third facing portion 314. In a case where the first alignment marks 50A are formed on the side of the third facing portion 314, the first alignment marks 50A are preferably formed so as to be recognizable from the side of the second facing portion 313 through the glass base material 310. In a case where the first alignment marks 50A can be observed from the side of the second facing portion 313, when alignment is performed at the time of mounting of the glass bridge 31 on the wiring layer 4, the first alignment marks 50A formed on the glass bridge 31 and the second alignment marks 50B formed on the wiring layer 4 can be recognized with a single camera from the side of the second facing portion 313 of the glass bridge 31, and further, position recognition and position correction can be performed with the camera until the glass bridge 31 comes into contact with the wiring layer 4. Thus, the accuracy of mounting of the glass bridge 31 is increased.

In a case where the first alignment marks 50A are formed on the side of the second facing portion 313, and the first alignment marks 50A and the second alignment marks 50B can be observed at the same time from the side of the second facing portion 313, when alignment is performed at the time of mounting of the glass bridge 31 on the wiring layer 4, the first alignment marks 50A formed on the glass bridge 31 and the second alignment marks 50B formed on the wiring layer 4 can be recognized with a single camera from the side of the second facing portion 313 of the glass bridge 31, and further, position recognition and position correction can be performed with the camera until the glass bridge 31 comes into contact with the wiring layer 4. Thus, the accuracy of mounting of the glass bridge 31 is increased.

### <Another Embodiment>

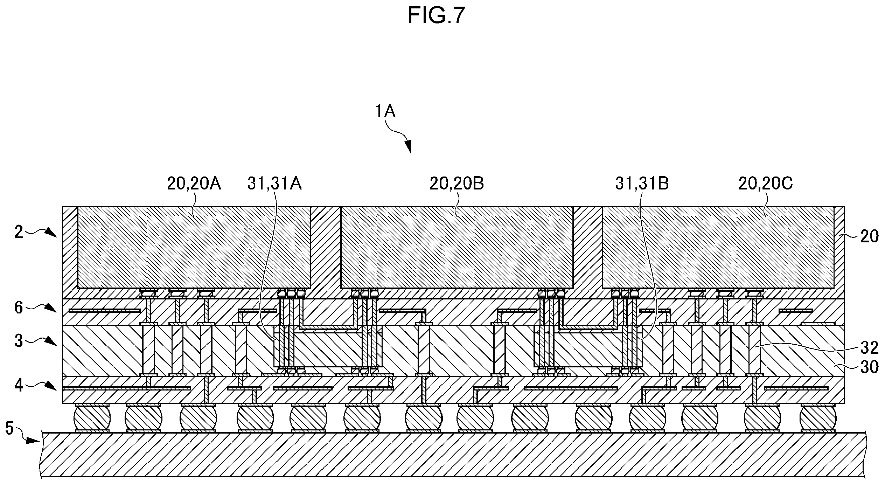

Referring now to Fig. 7, an electronic device 1A according to another embodiment of the present invention is described. Fig. 7 is a cross-sectional view of an electronic device according to another embodiment of the present invention. Note that the electronic device 1A has the same basic configuration as the electronic device 1, only different aspects will be described below.

The electronic device 1A includes a second wiring layer 6 between the electronic component layer 2 and the connection layer 3. Like the wiring layer 4, the second wiring layer 6 includes power supply wirings and ground wirings, and the power supply wirings and the ground wirings are connected to a power supply line and a ground line of the wiring layer 4, respectively, via the pillars 32. The second wiring layer 6 includes signal wirings, and, like the bridge wirings 311, these signal wirings are responsible for signal transmission among the electronic components 20A, 20B, and 20C. In the present embodiment, it is also possible to provide an electronic device 1 capable of mounting the bridges 31 on the wiring layer 4 with high positional accuracy.

An electronic device according to the present embodiment includes the following configurations.
(1) An electronic device 1 of the present embodiment includes a bridge 31 that electrically connects a plurality of electronic components 20, and a wiring layer 4 including wirings, in which the bridge 31 is metal-joined to the wiring layer 4. With this configuration, it is possible to provide an electronic device 1 capable of mounting the bridge 31 on the wiring layer 4 with high positional accuracy.
(2) In the electronic device 1 of (1), the plurality of electronic components 20 is provided, each of the electronic components 20 includes a first facing portion 200 facing the bridge 31, the bridge 31 includes a second facing portion 313 facing the first facing portions 200 of the electronic components 20 and a third facing portion 314 formed on the opposite side from the second facing portion 313, the bridge 31 includes a through bridge electrode 315 (a through bridge via 315) penetrating from the second facing portion 313 to the third facing portion 314, and the through bridge electrode 315 (the through bridge via 315) is metal-joined to the wiring layer 4. With this arrangement, the wiring length at the time of electrically connecting the electronic components 20 and another layer via the bridge 31 can be shortened, and the bridge 31 can be mounted on the wiring layer 4 with high positional accuracy. As the wiring length can be shortened as above, stable charge supply to the electronic components 20 can be conducted. As an example, the power supply lines of the electronic components 20 and the power supply line of the wiring layer 4 can be connected in a short distance. As another example, the ground lines of the electronic components 20 and the ground line of the wiring layer 4 can be connected in a short distance.
(3) In the electronic device 1 of (1) or (2), the bridge 31 further includes a bridge wiring 311 that electrically connects the electronic components 20 to each other. With this arrangement, exchange of electric power and information between the electronic components 20 can be directly performed through the bridge wiring 311.
(4) In the electronic device 1 of (3), the bridge 31 further includes a bridge insulating layer 312 that insulates the bridge wiring 311. With this arrangement, it is possible to suppress the occurrence of short-circuiting between the bridge wirings 311, and the occurrence of short-circuiting between the bridge wiring 311 and the through bridge via 315.
(5) In the electronic device 1 of (4), the bridge insulating layer 312 is an organic insulating layer. An organic insulating layer formed with a resin material generally has a low relative permittivity. Accordingly, as an organic insulating layer is used as the bridge insulating layer 312, dielectric loss can be further reduced. Further, as an organic insulating layer is used, the bridge insulating layer 312 can also be made thicker along with an increase in the thickness of the bridge wiring 311, and, even in this case, the manufacturing cost can be reduced.
(6) The electronic device 1 of any one of (1) to (4) includes an electronic component layer 2 including the plurality of electronic components 20, the wiring layer 4 having wirings, and a connection layer 3 that includes the bridge 31 and electrically connects the plurality of electronic components 20 and the wiring layer 4. In the electronic device 1 having such a configuration, the effects of the present disclosure can also be obtained.
(7) In the electronic device 1 of (6), the through bridge electrode 315 (the through bridge via 315) electrically connects the plurality of electronic components 20 and the wirings of the wiring layer 4. With this arrangement, the wiring length at the time of electrically connecting the electronic components 20 and another layer via the bridge 31 can be shortened.
(8) In the electronic device 1 of (6) or (7), the connection layer 3 includes an insulating layer 30 covering the periphery of the bridge 31, and a through-connection-layer electrode 32 (a pillar 32) that penetrates from the facing portion (the second facing portion 313) facing the electronic component layer 2 to the facing portion (the third facing portion 314) facing the wiring layer 4, and electrically connects the electronic components 20 and the wirings of the wiring layer 4 is formed in the insulating layer 30. With this arrangement, the electronic components 20 and the wirings of the wiring layer 4 can be electrically connected in a portion other than the bridge 31.
(9) In the electronic device 1 of any one of (6) to (8), the electronic components 20 are arranged so as to be adjacent to each other. With this arrangement, the electronic components 20 can be placed at a high density, and the electronic components 20 can be connected by the bridge 31.
(10) In the electronic device 1 of any one of (6) to (9), when the electronic component layer 2 and the connection layer 3 are viewed from the stacking direction, the bridge 31 is placed so as to overlap each of the electronic components 20. With this arrangement, the electronic components 20 can be densely placed in the electronic component layer 2. Accordingly, in the electronic device 1 having specified dimensions, the amount of information that can be processed by the electronic components 20 can be increased.
(11) In the electronic device 1 of any one of (1) to (10), the plurality of electronic components 20 includes at least a first electronic component 20A, a second electronic component 20B, and a third electronic component 20C, the bridge 31 includes a plurality of bridges 31, and the plurality of bridges 31 includes a first bridge 31A that electrically connects the first electronic component 20A and the second electronic component 20B to each other, and a second bridge 31B that electrically connects the second electronic component 20B and the third electronic component 20C to each other. In conventional cases, bridges are fixed to a wiring layer with an adhesive. In such cases, the positioning accuracy of the bridges with respect to the wiring layer was low. As flip-chip mounting by metal joining is possible in the present embodiment, the bridges 31 can be mounted with high positional accuracy. In particular, in a case where the plurality of bridges 31 is used in the electronic device 1 including three or more electronic components 20, if the positioning accuracy of the plurality of bridges 31 is low, it is difficult to appropriately mount the bridges 31. As flip-chip mounting by metal joining is possible in the present embodiment, the plurality of bridges 31 can be mounted with high positional accuracy.
(12) In the electronic device 1 of any one of (1) to (11), the bridge 31 is formed with a glass base material. With this arrangement, it is possible to provide the electronic device 1 in which the dielectric loss is reduced.
(13) In the electronic device 1 of (12), the bridge 31 includes the second facing portion 313 facing the first facing portions 200 of the electronic components 20, and the third facing portion 314 formed on the opposite side from the second facing portion 313, at least part of the bridge 31 is formed with a member capable of transmitting light from the second facing portion 313 to the third facing portion 314, and the bridge 31 includes a first alignment mark 50A. With this arrangement, the bridge 31 can be mounted after accurate alignment is performed, and thus, the bridge 31 can be mounted with higher positional accuracy.
(14) In the electronic device 1 of any one of (1) to (13), the bridge 31 is smaller than any of the electronic components 20. With this arrangement, the amount of use of the material forming the bridge 31 can be reduced, and thus, the cost can be lowered.
(15) A method for manufacturing an electronic device 1 including: a bridge 31 that electrically connects a plurality of electronic components 20; and a wiring layer 4 including wirings includes:
   a bridge manufacturing step of manufacturing the bridge 31; and a bridge mounting step of mounting the bridge 31 on the wiring layer 4,
   in which the bridge manufacturing step includes:
      a step of preparing a base material 310;
      a through-hole forming step of forming a through-hole in the base material 310;
      a through bridge electrode forming step of forming a through bridge electrode 315 (a through bridge via 315) in the through-hole;
      a bump electrode forming step of forming a bump electrode 203 corresponding to the through bridge electrode 315 (the through bridge via 315); and
      a cutting step of cutting the base material 310 into a member having a chip size, and
      the bridge mounting step includes:
         metal-joining the bridge 31 manufactured in the bridge manufacturing step to the wiring layer 4 by flip-chip mounting. With this configuration, it is possible to provide an electronic device 1 capable of mounting the bridge 31 on the wiring layer 4 with high positional accuracy.
(16) The method for manufacturing the electronic device 1 according to (15), in which
   the bridge 31 is formed with a translucent glass base material, and has a first alignment mark 50A (an alignment mark),
   the wiring layer 4 has a second alignment mark 50B corresponding to the first alignment mark 50A of the bridge 31, and
   in the bridge mounting step, the first alignment mark 50A formed on the bridge 31 and the second alignment mark 50B formed on the wiring layer 4 are recognized with a single camera, and the bridge 31 is metal-joined to the wiring layer 4 by flip-chip mounting. With this arrangement, the bridge 31 can be mounted after accurate alignment is performed, and thus, the bridge 31 can be mounted with higher positional accuracy.

Although embodiments of the present invention have been described above, the present invention is not limited to the above-described embodiments, and various changes and modifications can be made to them. As an example, corresponding components of the respective embodiments can be replaced with each other.

### Reference Signs List

- 1: electronic device
- 2: electronic component layer
- 20: electronic component
- 200: first facing portion
- 21: insulating layer
- 3: connection layer
- 30: insulating layer
- 31: bridge
- 310: base material
- 311: bridge wiring
- 312: bridge insulating layer
- 313: second facing portion
- 314: third facing portion
- 315: through bridge via (through bridge electrode)
- 32: pillar (through-connection-layer electrode)
- 4: wiring layer
- 42: first layer line wiring
- 43: first insulating layer
- 44: second layer line wiring
- 45: second insulating layer
- 46: third layer line wiring
- 47: first layer via wiring
- 48: second layer via wiring
- 49: bump electrode
- 5: substrate
- 50A: first alignment mark (alignment mark)
- 50B: second alignment mark

## Claims

1. An electronic device comprising:
a bridge that electrically connects a plurality of electronic components; and
a wiring layer including a wiring,
wherein the bridge is metal-joined to the wiring layer.

2. The electronic device according to claim 1, wherein
the plurality of electronic components is provided,
each of the electronic components includes a first facing portion facing the bridge,
the bridge includes a second facing portion facing the first facing portions of the electronic components, and a third facing portion formed on an opposite side from the second facing portion,
the bridge further includes a through bridge electrode penetrating from the second facing portion to the third facing portion, and
the through bridge electrode is metal-joined to the wiring layer.

3. The electronic device according to claim 1, wherein the bridge further includes a bridge wiring that electrically connects the electronic components to each other.

4. The electronic device according to claim 3, wherein the bridge further includes a bridge insulating layer that insulates the bridge wiring.

5. The electronic device according to claim 4, wherein the bridge insulating layer is an organic insulating layer.

6. The electronic device according to claim 2, further comprising:
an electronic component layer including the plurality of electronic components; and
a connection layer that includes the bridge, and electrically connects the plurality of electronic components and the wiring layer.

7. The electronic device according to claim 6, wherein the through bridge electrode electrically connects the plurality of electronic components and the wiring of the wiring layer.

8. The electronic device according to claim 6, wherein
the connection layer includes an insulating layer covering a periphery of the bridge, and
the insulating layer is formed with a through-connection-layer electrode that penetrates from a facing portion facing the electronic component layer to a facing portion facing the wiring layer, and electrically connects the electronic components and the wiring of the wiring layer.

9. The electronic device according to claim 6, wherein the electronic components are arranged adjacent to each other.

10. The electronic device according to claim 6, wherein, when the electronic component layer and the connection layer are viewed from a stacking direction, the bridge is placed to overlap each of the electronic components.

11. The electronic device according to claim 1, wherein
the plurality of electronic components includes at least a first electronic component, a second electronic component, and a third electronic component,
the bridge includes a plurality of bridges, and
the plurality of bridges includes a first bridge that electrically connects the first electronic component and the second electronic component to each other, and a second bridge that electrically connects the second electronic component and the third electronic component to each other.

12. The electronic device according to claim 1 or 2, wherein the bridge is formed with a glass base material.

13. The electronic device according to claim 12, wherein
the bridge includes a second facing portion facing the first facing portions of the electronic components, and a third facing portion formed on an opposite side from the second facing portion,
at least part of the bridge is formed with a member capable of transmitting light from the second facing portion to the third facing portion, and
the bridge includes an alignment mark.

14. The electronic device according to claim 1, wherein the bridge is smaller than any of the electronic components.

15. A method for manufacturing an electronic device including: a bridge that electrically connects a plurality of electronic components; and a wiring layer including a wiring,
the method comprising:
a bridge manufacturing step of manufacturing the bridge; and a bridge mounting step of mounting the bridge on the wiring layer,
wherein the bridge manufacturing step includes:
a step of preparing a base material;
a through-hole forming step of forming a through-hole in the base material;
a through bridge electrode forming step of forming a through bridge electrode in the through-hole;
a bump electrode forming step of forming a bump electrode corresponding to the through bridge electrode; and
a cutting step of cutting the base material into a member having a chip size, and
the bridge mounting step includes
metal-joining the bridge manufactured in the bridge manufacturing step to the wiring layer by flip-chip mounting.
